**Europäisches Patentamt**

**European Patent Office**

**Office européen des brevets**

(19)

(11) Veröffentlichungsnummer: **0 060 925**
**B1**

(12) **EUROPÄISCHE PATENTSCHRIFT**

(45) Veröffentlichungstag der Patentschrift:
20.03.85

(51) Int. Cl.⁴: **G 01 R 31/28**

(21) Anmeldenummer: 81108737.8

(22) Anmeldetag: 22.10.81

(54) **Aufzeichnung von sich nicht zyklisch wiederholenden logischen Zustandsänderungen an einer Messstelle im Inneren von integrierten Schaltungen mit der Elektronensonde.**

(30) Priorität: 16.03.81 DE 3110137

(43) Veröffentlichungstag der Anmeldung:
29.09.82 Patentblatt 82/39

(45) Bekanntmachung des Hinweises auf die Patenterteilung:
20.03.85 Patentblatt 85/12

(84) Benannte Vertragsstaaten:
DE FR GB NL

(56) Entgegenhaltungen:
US - A - 3 549 999

IEEE JOURNAL OF SOLID STATE CIRCUITS, vol. SC 14, no. 2, April 1979, New York, E. WOLFGANG et al. "Electron-beam testing of VLSI circuits", Seiten 471 - 481
SCANNING ELECTRON MICROSCOPY, 1979, AMF O Hare, Illinois, H.P. FEUERBAUM "VLSI Testing using electron probe", Seiten 285-296
SEM (1978),S. 375-380
Beitr. elektronenmikroskop. Direktabb. Oberfl. (1975) 8, S. 469-480
SEM (1979), S. 285-296

(73) Patentinhaber: *Siemens Aktiengesellschaft, Berlin und München Wittelsbacherplatz 2, D-8000 München 2 (DE)*

(72) Erfinder: **Fazekas, Peter, Dipl.-Ing., Stuntzstrasse 21, D-8000 München 80 (DE)**

**Beschreibung**

Die Erfindung betrifft ein Verfahren zur Aufzeichnung von logischen Zuständen nach dem Oberbegriff des Anspruchs 1.

In komplexen logischen Schaltungen, wie z.B. bei Mikroprozessoren und Mikrocomputern, können Fehler in der Logik dieser komplexen Schaltungen zu einer nicht zyklischen Veränderung des abzuarbeitenden Programms führen. Da solche Fehler nur in einem nicht-zyklischen Test-Programmablauf analysiert werden können, können keine Messverfahren angewandt werden, welche eine zyklische Wiederholung von Test-Programmabläufen erfordern.

Logische Zustände, welche sich nicht zyklisch wiederholen, können mit Logikanalysatoren aufgezeichnet werden. Nach einem bekannten Verfahren können dabei im Inneren integrierter Schaltungen logische Zustandsänderungen, welche sich nicht zyklisch wiederholen, dadurch aufgezeichnet werden, dass auf die zu überprüfende Messstelle eine mechanische Messspitze aufgesetzt wird. Für Schaltungsstrukturen mit einer Ausdehnung der Messstellen von wenigen tausendstel Millimetern verbietet sich die Verwendung von mechanischen Messspitzen aus mechanischen und kapazitiven Gründen.

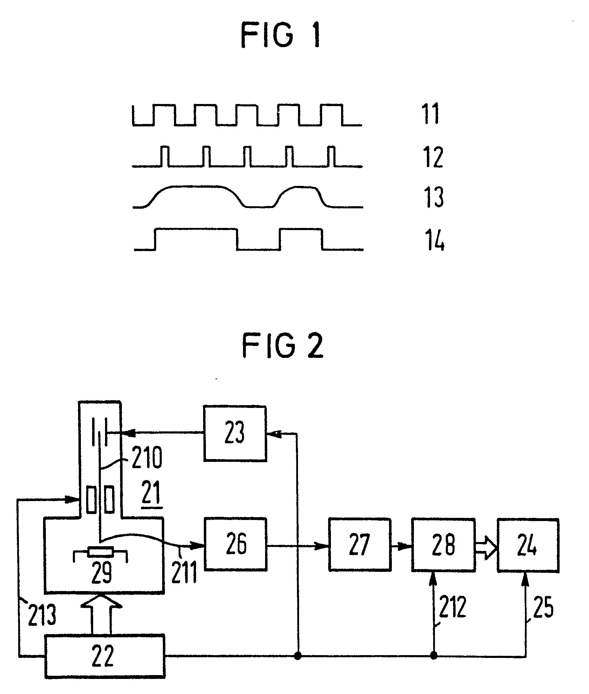

Aus einer Veröffentlichung von Hans-Peter Feuerbaum, Beitr. elektronenmikroskop. Direktabb. Oberfl. 11 (1978), Seiten 67-71, ist eine experimentelle Anordnung und ein Verfahren der stroboskopischen Aufzeichnung von logischen Zuständen an Messpunkten im Inneren einer integrierten Schaltung bekannt (insbesondere Abb. 2 und Abb. 3 nebst Beschreibung). Bei der Messung eines hochfrequenten Signalverlaufs an einem Messpunkt im Inneren einer integrierten Schaltung wird dabei der Elektronenstrahl synchron zu dem hochfrequenten Signal am Messpunkt gepulst. Die Primärelektronen lösen dabei am Messpunkt Sekundärelektronen aus. Diese Sekundärelektronen werden erfasst und in ein elektrisches Messsignal umgesetzt. Während einer jeden Periode des hochfrequenten Signalverlaufs an einem Messpunkt trifft genau ein Elektronenpuls auf diesen Messpunkt auf und löst dabei genau ein einziges Potentialkontrastsignal aus. Zur Messung einer gesamten Periode des Signalverlaufs am Messpunkt wird dabei die Phase der Elektronenpulse bezüglich des hochfrequenten Signalverlaufs am Messpunkt über eine ganze Periode dieses Signalverlaufs hinweggeschoben. Da nach dem Stand der Technik während des einmaligen Verlaufs eines Signals an einem Messpunkt nur ein einziges Potentialkontrastsignal gewonnen werden kann, kann nach dem Stand der Technik während eines einmaligen Verlaufs dieses Signals nur Information darüber erhalten werden, wie zu einem einzigen ganz bestimmten Phasenpunkt innerhalb der Periode des Signals der Wert des Signals beschaffen ist. Um Aussagen über Signalwerte auch zu anderen Phasenpunkten innerhalb der Periode des Signalverlaufs machen zu können, muss der Signalverlauf periodisch am Messpunkt wiederholt werden. Die Aufzeichnung eines nicht zyklischen Signalverlaufs, der sich über mehrere Grundtakte hinweg erstreckt, ist mit einem Verfahren nach dem Stand der Technik nicht möglich.

Der Erfindung liegt die Aufgabe zugrunde, ein Verfahren der eingangs genannten Art anzugeben, mit welchem Logikfehler auch in hochintegrierten logischen Schaltungen festgestellt werden können, auch wenn sich die dabei auftretenden, sich nicht zyklisch wiederholenden logischen Zustände über mehrere Grundtakte hinweg erstrecken, wobei ein Grundtakt der hochintegrierten logischen Schaltung von etwa 10 MHz zulässig ist.

Diese Aufgabe wird erfindungsgemäss durch ein eingangs genanntes Verfahren gelöst, welches die kennzeichnenden Merkmale des Anspruchs 1 aufweist.

Wenn die zu überprüfende komplexe logische Schaltung ein stabiles Fehlerbild aufweist, können von verschiedenen Messstellen Potentialkontrastsignalverläufe aufgezeichnet werden, wobei der Ablauf dieser Aufzeichnungen jeweils an definierten Stellen eines Test-Programmablaufs gestartet wird. Um die logisch bewerteten Potentialsignalkontrastverläufe der einzelnen Messstellen mit dem Logikentwurf für diese Messstellen vergleichen zu können, werden von verschiedenen Messstellen logisch bewertete Potentialkontrastsignalverläufe bei einer jeden Messstelle jeweils in Echtzeit hintereinander aufgezeichnet und schliesslich parallel miteinander verglichen.

Mit einem erfindungsgemässen Verfahren kann die zeitliche Folge logischer Zustände auf mehreren Datenleitungen von Mikroprozessoren oder Mikrocomputern parallel in einem Logikdiagramm dargestellt werden. Werden die logisch bewerteten Potentialkontrastsignale der einzelnen Messstellen einem Logikanalysator [J. MecLeod, «Logic Analyzers-Sharp fault-finders getting sharper», Electronic Design, 28 (1970) 7, S. 48-56] zugeführt, so können in diesem Logikanalysator die Logikdiagramme der verschiedenen Messstellen parallel dargestellt werden.

Die Erfindung ist in der Zeichnung dargestellt und wird im folgenden näher erläutert.

Fig. 1 illustriert die Aufzeichnung von sich nicht zyklisch wiederholenden logischen Zuständen an einer Messstelle im Inneren einer integrierten Schaltung.

Fig. 2 zeigt eine Vorrichtung, mit der ein erfindungsgemässes Verfahren durchgeführt wird.

Mit einem erfindungsgemässen Verfahren ist es möglich, bei Vorliegen eines logischen Fehlers auch in einer hochintegrierten logischen Schaltung logische Zustandsänderungen, welche sich nicht zyklisch wiederholen, an einer Messstelle im Inneren dieser integrierten Schaltung aufzuzeichnen. Fig. 1 illustriert dieses erfindungsgemässe Verfahren. Die zu überprüfende logische Schaltung wird mit einem Grundtakt 11 angesteuert. Die Elektronensonde wird auf eine zu überprüfende Messstelle aufgesetzt. Wenn der Ablauf des Test-Programms in der logischen Schaltung gestartet wird, wird der logische Zustand der Messstelle während eines jeden Pulses des Grundtaktes 11 mit einem Eintastpuls 12 abgefragt. Die Abbildung der logischen Zustände erfolgt dabei durch den Potentialkontrast: Logisch «0» erscheint hell und logisch «1» erscheint dunkel (A. Gopinath et al, «Voltage contrast: a review» SEM/1978 pp. 375-380 und H.-P. Feuerbaum et al, «qualitative and quantitative voltage measurement on integrated circuits», Beiträge elektronenmikroskopischer Direktabbildungen Oberfl., Vol. 8 pp. 469-480, 1975). Die Verweilzeit des Elektronenpulses auf der Messstelle ist dabei so gewählt, dass die logischen Zustände «0» und «1» sicher unterschieden werden können. Die Messung wird in einem Raster-Elektronenmikroskop durchgeführt. Das dabei auftretende Videosignal wird logisch bewertet und einem kommerziellen Logikanalysator zugeführt, der das Messsignal 14, welches die logischen Zustandsänderungen an der Messstelle im Inneren der integrierten Schaltung darstellt, mit einem externen Takt übernimmt, wobei der externe Takt um die Laufzeiten der Elektronenstrahlen gegenüber dem Grundtakt 11 der zu überprüfenden logischen Schaltung verzögert ist, jedoch dieselbe Frequenz wie dieser Grundtakt 11 aufweist. Das Signal 13 gibt den Potentialkontrastsignalverlauf an der Messstelle wieder und das Messergebnis 14 gibt den logisch bewerteten Potentialkontrastsignalverlauf an dieser Messstelle wieder.

Weist die zu überprüfende logische Schaltung einen definierbaren logischen Fehler auf, so zeigt das an einer Messstelle gewonnene Messergebnis 14 ein stabiles Fehlerbild. Um den logischen Fehler der zu überprüfenden integrierten Schaltung, der aufgrund des Messergebnisses 14 als definiert erkannt worden ist, analysieren zu können, müssen von verschiedenen Messstellen Messergebnisse 14 aufgezeichnet werden. Bei jeder Erstellung eines Messergebnisses 14 an einer neuen Messstelle muss jeweils der Ablauf des Test-Programms in definierter Weise von neuem gestartet werden.

Zur Untersuchung von Mikroprozessoren und Mikrocomputern mit Datenbreiten von z.B. 16 bit und mehr können z.B. Vorgänge auf allen Datenleitungen parallel dargestellt werden. Mit einem erfindungsgemässen Verfahren kann dies dadurch erreicht werden, dass bei jeder Datenleitung an einer Messstelle die logische Zustandsänderung während eines Test-Programmablaufs in einem Messergebnis 14 in Echtzeit gewonnen werden und dass schliesslich die Messergebnisse 14 von Messstellen von sämtlichen Datenleitungen parallel zueinander abgebildet werden. Diese parallele Abbildung der Messergebnisse 14 von Messstellen an sämtlichen Datenleitungen kann als Logikdiagramm bezeichnet werden, auch wenn die zu überprüfende logische Schaltung einen definierten Logikfehler aufweist.

Bei der Untersuchung einer logischen Schaltung mit einer grossen Datenbreite können die einzelnen Messergebnisse 14 hintereinander aufgezeichnet und in schnellen Schieberegistern zwischengespeichert werden. Wenn alle Messergebnisse 14 in dem Zwischenspeicher aufgezeichnet sind, können die Zwischenspeicherinhalte parallel in einen Logikanalysator übernommen werden. Die Zeitdiagramme der verschiedenen Messstellen können vom Logikanalysator parallel dargestellt werden.

Fig. 2 zeigt das Blockschaltbild einer Vorrichtung zur Durchführung eines erfindungsgemässen Verfahrens. Diese Vorrichtung basiert auf einem modifizierten Raster-Elektronenmikroskop 21 (Etec-Autoscan) (E. Wolfgang et al, «Internal Testing of Microprocessor, chips using Electron beam Techniques», Proceedings of IEEE International Conference on Circuits and Computers 1980, pp. 548-551, 1980). Der Ablauf eines erfindungsgemässen Verfahrens wird von einer Ansteuerung 22 kontrolliert. Die Ansteuerung 22 besteht aus einem Rechner (interdata 6/16), welcher den Ablauf der Messung kontrolliert, und bei Untersuchung z.B. eines nicht passivierten 8085 Mikroprozessors 29, der in einer geschrumpften Version bei SIEMENS entwickelt und hergestellt wurde, aus einem Mikroprozessor-Laboratorium (HP $\mu$-Lab 5036 A). Die Positionierung der Elektronensonde auf die einzelnen Messstellen erfolgt mittels eines digitalen Rastergeneratorsignals 213. Der Schiebetakt 212 bewirkt die Übernahme der bewerteten Messwerte (logisch «0» oder «1») in den Zwischenspeicher 28. Sind alle Messergebnisse 14 im Zwischenspeicher 28 gespeichert, werden sie vom Logikanalysator 24 (Biomation K 100) mit einem externen Takt 25, der von einem Verzögerungsgenerator beeinflusst wird, übernommen. Bewertet wird das Videosignal, welches am Ausgang des Videoverstärkers 26 anliegt, mittels einer Schmitt-Trigger-Schaltung 27 (H.-P. Feuerbaum, «VLSI Testing Using the Electron probe», SEM/1979, pp. 285-296, 1979). Mit 210 ist die gepulste Elektronensonde, mit 211 das Sekundärelektronenkollektorsignal und mit 23 der Pulsgenerator bezeichnet.

Die Zeitauflösung einer Vorrichtung nach Fig. 2 hängt von der Breite der Elektronenpulse ab. Derzeit sind routinemässig 1 ns breite Elektronenpulse erzielbar. Ein erfindungsgemässes Logikdiagramm einer zu überprüfenden logischen Schaltung kann extrem schnell aufgezeichnet werden, weil durch die in Analogie zum Vektor-Scan-Princip beim Elektronenstrahl-Schreiber sog. «Vektorsonden»-Technik nur die relevanten Messwerte erfasst werden.

Mit einem erfindungsgemässen Verfahren können logische Zustandsänderungen nicht nur an Datenleitungen, sondern ebenso an Steuerleitungen und an Adressleitungen überprüft werden.

Zur Auswertung der Messergebnisse 14 können diese Messwerte 14 auch direkt in einen Rechner eingespeichert und dort in beliebiger Weise ausgewertet werden.

**Patentansprüche**

1. Verfahren zur Aufzeichnung von sich nicht zyklisch wiederholenden logischen Zuständen, die an einer Messstelle in einer taktgesteuerten integrierten Logikschaltung (29) während der Ausführung eines Testprogramms in dieser Logikschaltung auftreten, dadurch gekennzeichnet, dass
— die Messstelle mit Elektronenpulsen (210) beaufschlagt wird, die in Frequenz und Phase mit dem Grundtakt der Logikschaltung übereinstimmen,
— mit einem definierten Start des Testprogramms die von jedem Elektronenpuls ausgelösten Sekundärelektronen (211) jeweils erfasst und in ein elektrische Messsignal umgesetzt werden, das nach einer logischen Bewertung registriert wird.

2. Verfahren nach Anspruch 1, dadurch gekennzeichnet, dass dem genannten elektrischen Messsignal entsprechende weitere Messsignale an weiteren Messstellen registriert werden, wobei der Ablauf des Testprogramms bei jeder Aufzeichnung eines weiteren Messsignals neu gestartet wird.

3. Verfahren nach Anspruch 2, dadurch gekennzeichnet, dass die Messsignale einer jeden Messstelle in Echtzeit hintereinander aufgezeichnet und anschliessend parallel verglichen werden.

## Claims

1. A method of recording logic states which repeat in non-cyclic fashion at a measurement point in a clock-pulse-controlled integrated logic circuit (29) during the execution of a test programme in this logic circuit, characterised in that:
— the measurement point is acted upon by a pulsed electron beam (210) whose pulses are identical in frequency and phase with the fundamental clock pulse train of the logic circuit; and
— following a determinate start of the test programme the secondary electrons (211) triggered by each electron beam pulse are respectively detected and converted into an electrical measurement signal which is recorded following logic evaluation.

2. A method as claimed in Claim 1, characterised in that further measurement signals corresponding to the aforementioned electrical measurement signal are recorded at further measurement points, the flow of the test programme being restarted with each recording of a further measurement signal.

3. A method as claimed in Claim 2, characterised in that the measurement signals of each measurement point are recorded consecutively in real time, and are then compared in parallel.

## Revendications

Procédé pour enregistrer des états logiques, qui ne se répètent pas cycliquement et qui apparaissent au niveau d'un point de mesure dans un circuit logique intégré (29), commandé de façon cadencée, pendant l'exécution d'un programme de test, caractérisé par le fait que:
— le point de mesure est chargé avec des impulsions électroniques (210) dont la fréquence et la phase coïncide avec la cadence de base du circuit logique,
— que lors d'un déclenchement défini du programme de test, les électrons secondaires (211) déclenchés par chaque impulsion électronique sont respectivement détectés et sont convertis en un signal électrique de mesure, qui est enregistré conformément à une pondération logique.

2. Procédé suivant la revendication 1, caractérisé par le fait que des signaux supplémentaires de mesure, qui correspondent au signal électrique de mesure indiqué, sont enregistrés en d'autres points de mesure, l'exécution du programme de test étant à nouveau déclenchée lors de chaque enregistrement d'un signal de mesure supplémentaire.

3. Procédé suivant la revendication 2, caractérisé par le fait que les signaux de mesure de chaque point de mesure sont enregistrés successivement en temps réel et sont ensuite comparés en parallèle.

# FIG 1

11

12

13

14

# FIG 2